# EUROPEAN PATENT APPLICATION

(11) **EP 4 804 780 A1**
(43) Date of publication of application: **09.09.2026**
(21) Application number: 25162117.3
(22) Date of filing: 06.03.2025
(51) Int. Cl.: H10N 70/20

(54) **RESISTIVE DEVICE AND METHOD FOR MANUFACTURING THE SAME**

(71) Applicant: Commissariat à l'Energie Atomique et aux Energies Alternatives, 75015 Paris (FR)
(72) Inventor: NGUYEN, NGOC-ANH, 38054 GRENOBLE CEDE 09 (FR); BOURGEOIS, GUILLAUME, 38054 GRENOBLE CEDEX 09 (FR); NAVARRO, GABRIELE, 38054 GRENOBLE CEDEX 09 (FR)
(74) Representative: Lebkiri, Alexandre

(57) **Abstract**

The invention has for object a resistive device comprising a first conductive electrode, a second conductive electrode and a layer made of an active material, called active layer; the second electrode comprises a solid cylinder contacting the first face of the active layer, a hollow cylinder of same diameter as the diameter of the solid cylinder and positioned facing the solid cylinder, and a hollow truncated cone, the first end of the hollow truncated cone having the same diameter as the diameter of the hollow cylinder and being positioned facing the hollow cylinder, the second end of the hollow truncated cone having a diameter strictly greater than the diameter of the first end of the hollow truncated cone. The diameter of the first end of the hollow truncated cone is between 19 nm and 100 nm, the diameter of the second end of the hollow truncated cone is between 14 nm and 32 nm and the angle between the sides of the hollow truncated cone and the top surface of the hollow cylinder is between 75° and 87°.

## Description

### TECHNICAL FIELD OF THE INVENTION

The technical field of the invention relates to a resistive device, especially a non-volatile memory and more particularly implementing a Phase Change Material memory, referred to as a PCM memory.

### TECHNOLOGICAL BACKGROUND OF THE INVENTION

A non-volatile memory implementing a phase change material (PCM) can be characterised by its resistance, which can take reversibly at least two distinct values. Each resistance value corresponds to a distinct state that the memory can assume, thus enabling binary information to be stored. A high resistance value corresponds to a "RESET" state, generally associated with a low state or "0". A low resistance value corresponds to a state referred to as "SET", generally associated with a high state or "1".

The memory can be programmed from one state to another, or from one resistance value to another, using steps referred to as "RESET" or "SET" programming.

A PCM memory typically contains a layer of PCM material such as chalcogenide glass material that can be switched reversibly between two solid phases, crystalline and amorphous states. These two phases represent "1" and "0" states respectively in binary systems. The phase transition can be achieved by changing the temperature of the phase change material induced by melting and fast cooling (melt-quenching) through electrical Joule heating effect.

More precisely, "RESET" programming is based on melting of all or part of the volume of the phase-change material, which is achieved by an electrical pulse with a sufficiently high current. The current is dimensioned to enable a melting temperature of the PCM material to be reached by Joule effect. Sudden cooling, obtained by virtue of a rapid reduction in the current applied, leaves the molten part of the PCM material in an amorphous state. This amorphous arrangement has a high resistance, corresponding to the RESET state.

On the other hand, "SET" programming is based on obtaining a crystalline state of the PCM material. This operation consists in applying an electrical pulse which produces, by the Joule effect, a partial or total melting of the PCM material. A gradual reduction in the current applied allows the PCM material to recrystallise. This crystalline state, with its lower resistance, corresponds to the SET state.

The current induced effect is provided to the memory thanks to two metallic elements (electrodes) sandwiching the PCM active layer. In many PCM devices, one of the two electrodes has a smaller contact area with the active layer than the other, causing the current density to be higher around this electrode. Thus, the programmable region of the PCM device is localized. This electrode is referred to as a heater or heating element. The heater can also provide a serial resistance that limits the programming current and contributes to the thermal confinement and hotspot placing of the device. Therefore, engineering the heater that allows for smaller interfacial contact between electrode and PCM material, sufficient serial resistance, and good thermal isolation is of great importance to improve the power efficiency of PCM devices.

Document "Optimization Metrics for Phase Change Memory (PCM) Cell Architectures" (M. Boniardi & al., IEDM14 IEEE 2014) discloses a non-volatile memory comprising a layer of PCM material and a heater connected in series. The heater is especially of the "Wall" type, i.e. having a fin shape, extending perpendicularly to the plane of the layers. Thus, the contact between the PCM layer and the heater is small, enabling high current densities to be achieved at the contact point. PCM device with Wall-type heater, whose bottom cuboid electrode is developed by depositing, patterning, and polishing a metal layer on a vertical dielectric trench, is widely considered for industrial memory products. This form of electrode allows for sufficiently high serial resistance for current limitation purposes. However, one drawback of the homogenous shape of a wall type heater is that we can observe an important heat loss along the heater. Besides, the thickness of the metal film and the lateral dimension of the metal strip give the contact area between the heater and the PCM material. The latter factor is strongly dependent on lithography limitation inducing certain limits in lateral and vertical shrinking, especially for more advanced nodes and bigger processing wafers.

To reduce the interfacial area between the heater and the PCM material, cone-shaped electrodes are also known. These electrodes have the shape of a 3D truncated cone with two ends: the smaller diameter side is in contact with PCM material, and the other side is shorted with the metal lines. Such a structure is for instance disclosed in the patent document US11910731. The asymmetric electrode disclosed in this document achieves the fact of reducing the contact area between the metallic element and the PCM layer, increasing thus the current density for cell programming. However, a major drawback of this design is the total resistance of this solid cone (i.e. completely filled with conductive material) electrode which has a very low resistance.

Another known structure of electrode is disclosed in the patent document CN102237488. Said electrode has the shape of a hollow-truncated cone on top of the PCM material.

The asymmetric electrodes disclosed in the above cited documents achieves the first aspect of reducing the contact area between the metallic element and the PCM layer, thus, increasing the current density for cell programming. However, the latter document does not target a specific set of dimensions for their hollow cones. It is crucial to get a desired resistance of the electrode that should be in the range of 4.5 kΩ - 5.5 kΩ. Lower than this can lead to degradation of the current limit function, while higher resistive values can cause higher operation energy consumption and detrimentally higher voltage drop for each cell.

Therefore, there is a need for a resistive device such as a PCM memory easy to manufacture, presenting a small interface between electrode and active material, having a heater resistance that is neither too high nor too low in order to avoid, on one hand, degradation of the current limit function and, on the other, hand higher operation energy consumption and detrimentally higher voltage drop for, and limiting the thermal loss along the heater.

### SUMMARY OF THE INVENTION

The invention provides a solution to the previously discussed problems. The invention more particularly relates to a resistive device comprising:
- a first conductive electrode,
- a second conductive electrode; and
- a layer made of an active material, called active layer, said active layer being between the first electrode and the second electrode, a first face of the active layer being electrically connected to the second electrode and a second face of the active layer being electrically connected to the first electrode;
wherein the second electrode comprises:
- a solid cylinder contacting the first face of the active layer either directly or through a protecting layer,
- a hollow cylinder of same outer diameter as the outer diameter of the solid cylinder and positioned facing the solid cylinder, and
- a hollow truncated cone having a first end and a second end, the first end of the hollow truncated cone having the same outer diameter as the outer diameter of the hollow cylinder and being positioned facing the hollow cylinder, the second end of the hollow truncated cone having an outer diameter strictly greater than the outer diameter of the first end of the hollow truncated cone,
the outer diameter of the first end of the hollow truncated cone being between 14 nm and 32 nm, the outer diameter of the second end of the hollow truncated cone being between 19 nm and 100 nm and the angle between the sides of the hollow truncated cone and the top surface of the hollow cylinder being between 75° and 87°.

Thanks to the invention and compared to the known device of the prior art, especially the one of the document CN102237488, the dimension ranges of the second electrode, that may be a heater in a PCM device, are settled in order to obtain optimal performance of the resistive device. Accordingly, the dimension ranges of the device of the invention provide a second electrode having a resistance in the range 4.5 kΩ - 5.5 kΩ. Moreover, in addition to the solid cylinder part and the hollow truncated cone part, the second electrode comprises an additional part having a hollow cylinder shape allowing a better fine tuning of the performances of the resistive device. Besides, with similar current density to that of Wall electrode structure, the heat is well concentrated below the second electrode region. Moreover, the truncated conical symmetry of the heater provides a resistance gradient, in which the further from the contact, the higher in resistance. As a result, we observe much less heat loss along the heater compared to a homogenous Wall electrode.

Besides the features just discussed in the previous paragraph, the device according to the invention can have one or more of the complementary features from the following ones, considered individually or according to any technically possible combinations:
- the outer diameter of the first end of the hollow truncated cone is between 30 nm and 100 nm;
- advantageously, the height of the hollow truncated cylinder is between 30 and 150 nm;
- advantageously, the height of the solid cylinder is between 1 nm and 5 nm;
- advantageously, the cumulated height of the hollow cylinder and the solid cylinder is between 5 nm and 10 nm;
- in a very advantageous situation, the following combination allows to obtain an optimal performance of the device: the outer diameter of the first end of the hollow truncated cone being between 19 nm and 100 nm, the outer diameter of the second end of the hollow truncated cone being between 14 nm and 32 nm, the angle between the sides of the hollow truncated cone and the top surface of the hollow cylinder being between 75° and 87°, the height of the hollow truncated cylinder is between 50 and 100 nm, the height of the solid cylinder is between 1 nm and 5 nm and the cumulated height of the hollow cylinder and the solid cylinder is between 5 nm and 10 nm;
- said device is a phase change memory, said active layer being made of a phase change material and said second electrode being the heater of said phase change memory;
- said phase change material is a chalcogenide material;
- a dielectric material surrounds the external sides of the hollow truncated cone, said hollow truncated cone and said hollow cylinder being also filled with a dielectric material;
- the device according to the invention comprises a protection layer located between said active layer and said second electrode;
- said second electrode is at least part of the top electrode of the device and said first electrode is the bottom electrode of the device.

**The** invention also relates to a method for manufacturing a resistive device comprising the steps of:
- Providing a conductive layer adapted to form a first conductive electrode ;
- Depositing a layer made of an active material;
- Depositing a protecting layer;
- Depositing an etch stop layer;
- Depositing an insulating layer;
- Etching the insulating layer and the etch stop layer with stopping on the surface of the protecting layer, so as to pattern a cavity having a hollow cylinder shape through the etch stop layer and a hollow truncated cone shape having a first end and a second end, the first end of the hollow truncated cone having the same outer diameter as the outer diameter of the hollow cylinder and being positioned facing the hollow cylinder, the second end of the hollow truncated cone having an outer diameter strictly greater than the outer diameter of the first end of the hollow truncated cone;
- Conformally depositing a conductive layer on the flank and the bottom of the cavity so as to form a second conductive electrode comprising:
   - a solid cylinder contacting the first face of the protecting layer,
   - a hollow cylinder of same outer diameter as the outer diameter of the solid cylinder and positioned facing the solid cylinder, and
   - a hollow truncated cone having a first end and a second end, the first end of the hollow truncated cone having the same outer diameter as the outer diameter of the hollow cylinder and being positioned facing the hollow cylinder, the second end of the hollow truncated cone having an outer diameter strictly greater than the outer diameter of the first end of the hollow truncated cone;
   the outer diameter of the first end of the hollow truncated cone being between 14 nm and 32 nm, the outer diameter of the second end of the hollow truncated cone being between 19 nm and 100 nm and the angle between the sides of the hollow truncated cone and the top surface of the hollow cylinder being between 75° and 87°.

Besides the features just discussed in the previous paragraph, the method according to the invention can have one or more of the complementary features from the following ones, considered individually or according to any technically possible combinations:
- the manufacturing method according to the invention comprises a step of depositing an insulation layer so as to fill said hollow truncated cone and said hollow cylinder;
- the manufacturing according to the invention comprises a step of polishing so as to obtain a desired height of the second conductive electrode and the desired outer diameter of the second end of the hollow truncated cone.
- the height of the hollow truncated cylinder is between 50 and 100 nm and the height of the solid cylinder is between 1 nm and 5 nm.
- the manufacturing method of the invention comprises a step of depositing a conductive layer contacting the top part of the second electrode so as to form a top electrode contact.

### BRIEF DESCRIPTION OF THE FIGURES

The invention and its different applications will be better understood upon reading the following description and upon examining the accompanying figures. The figures are set forth by way of indicating and in no way limiting the purposes of the invention.
Fig. 1 shows a cross-sectional view of an example of a resistive device according to the invention, said device being a Phase Change Memory memory cell.
Fig. 2 a shows a schematic top view of the heating second electrode of the device illustrated in Fig. 1.

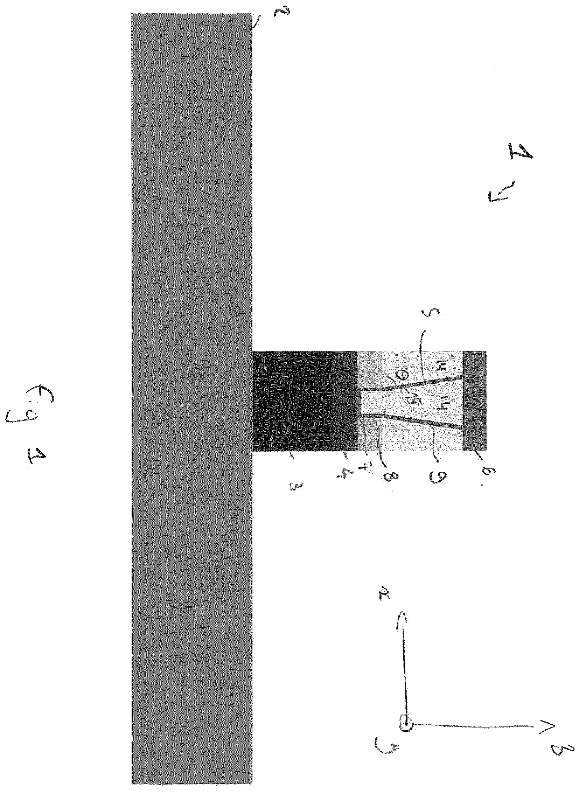

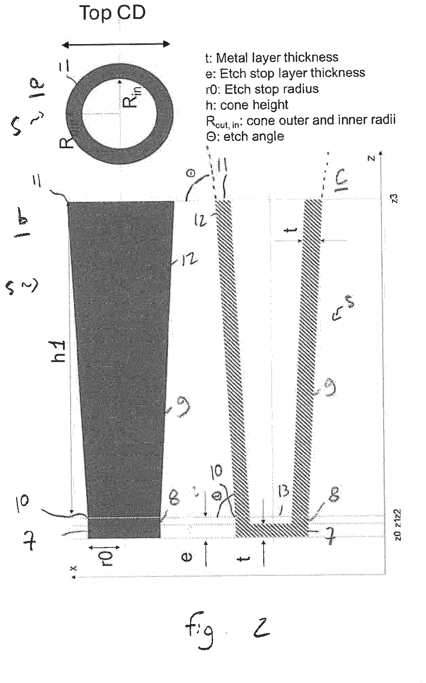

Fig.2 b shows a schematic lateral view of the heating second electrode of the device illustrated in Fig. 1.
Fig. 2 c shows a schematic cross-sectional lateral view of the heating second electrode of the device illustrated in Fig. 1.

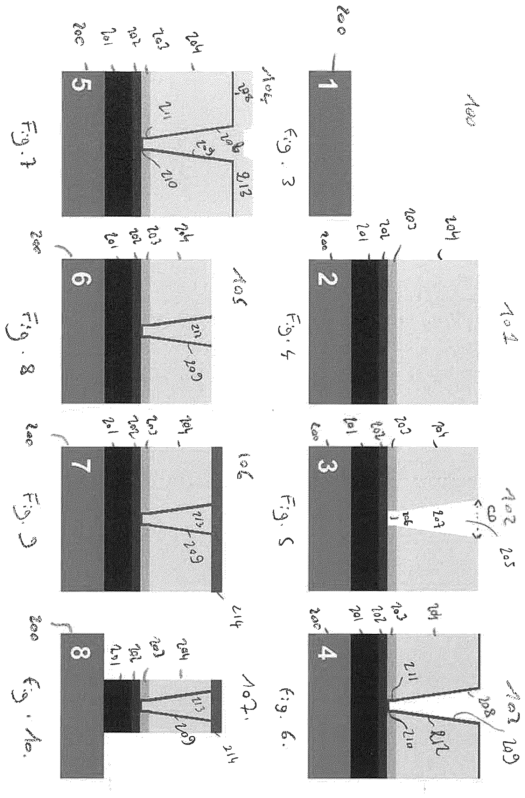

Fig. 3 to Fig. 10 illustrate the steps of a manufacturing method according to the invention.

Unless otherwise specified, a same element appearing in different figures has a single reference.

For purposes of the description only, hereinafter, the terms "upper", "lower", "right", "left", "bottom", "vertical", "horizontal" and derivatives thereof shall relate to disclosed structures and methods, as oriented in the drawing figures.

### DETAILED DESCRIPTION

Fig. 1 shows a cross-sectional schematic view of a resistive device in accordance with an embodiment of the invention. Said resistive device is in the present case a phase change memory PCM cell 1.

The PCM cell 1 includes:
- a first electrode 2 (here the bottom electrode);
- an active layer 3 that is made of a PCM material;
- a protective layer 4
- a second electrode 5 (here the top electrode) covered by a top electrode contact 6.

The second electrode 5 is the heater of the PCM cell.

A top electrode of a device is defined as the electrode located above this device and the bottom electrode of a device as the electrode located below this device, the electrodes being located on either side of the device. Of course, the terms "top" and "bottom" are herein relating to the orientation of the assembly including top electrode, active material and bottom electrode such that by turning over this assembly, the electrode previously referred to as the top electrode becomes the bottom electrode and the electrode previously referred to as the bottom electrode becomes the top electrode.

One has to note that the protective layer 4 between the active layer and the second electrode 5 is optional and manufacturing process dependant. The role of the protective layer 4 is to protect the PCM material of the active layer 3 during the manufacturing method, the PCM material being especially sensitive to chemical etching and air. The protective layer 4 may be made of a material such as Ge, GeN or C-doped Ge.

The first electrode 2 may be arranged on a non-represented dielectric layer (for instance for single devices) or on a metal level at back end of the line (BEOL) (for instance for memory arrays).

Active layer 3 is an active material layer made for instance of a chalcogenide material such as a ternary material composed of germanium Ge, tellurium Te and antimony Sb; the active material may be for instance Ge₂Sb₂Te₅.

The first electrodes 2 is made of a conductive material. Such conductive material is for example W, Cu or any other conductive materials.

The second electrodes 5 is made of a conductive material. Such conductive material is for example TiN, Ti, TaN, W, TiW, TiWN or TiSiN.

Fig. 2 a shows a schematic top view of the heating second electrode 5. Fig.2 b shows a schematic lateral view of the heating second electrode 5. Fig. 2 c shows a schematic cross-sectional lateral view of the second electrode 5.

Said second electrode 5 comprises three distinct parts:
- a solid cylinder 7 having an outer diameter equal to 2.r0 where r0 is the radius of the solid cylinder 7,
- a hollow cylinder 8 of same outer diameter 2.r0 as the outer diameter of the solid cylinder 7 and positioned facing the solid cylinder, and
- a hollow truncated cone 9 having a first end 10 and a second end 11, the first end 10 of the hollow truncated cone 9 having the same outer diameter 2.r0 as the outer diameter 2.r0 of the hollow cylinder 8 and being positioned facing the hollow cylinder 8, the second end 11 of the hollow truncated cone 9 having an outer diameter strictly 2.Rout (where Rout is the outer radius of the second end 11 (i.e. top end) of the cone 9) greater than the outer diameter 2.r0 of the first end (i.e. bottom end) 10 of the hollow truncated cone 9.

By the term "hollow" (either for the truncated cone 9 and for the cylinder 8), it is meant that the flanks of the truncated cone 9 of the cylinder 8 form an inside empty cavity, without conductive material). By the term "solid" for the cylinder 7, it is meant that said cylinder 7 is completely filled with conductive material.

Said solid cylinder 7, hollow cylinder 8 and hollow truncated cone 9 are arranged successively along the z axis perpendicular to the plane of the different layers (for instance the active layer 3).

According to the invention, the outer diameter 2.Rout of the second end of the hollow truncated cone 9 is in the range comprised between 19 nm and 100 nm (and preferentially between 30 nm and 100 nm), the outer diameter 2.r0 of the first end of the hollow truncated cone 9 is in the range between 14 nm and 32 nm. Besides, according to the invention, the angle θ between the sides 12 of the hollow truncated cone 9 and the top surface plane 13 of the hollow cylinder 8 is comprised in the range between 75° and 87°.

Thanks to the above-mentioned selected dimensions ranges, the serial resistance of the heating second electrode belongs to the range 4.5 kΩ - 5.5 kΩ in order to limit well the programming current and thermal dissipation while preserving the good electrical conductivity of the second electrode. The range 4.5 kΩ - 5.5 kΩ corresponds to a resistivity ratio R/ρ (where R and ρ are respectively the resistance and the resistivity of the second electrode) in the range between 0.45 and 0.5.

Besides, it is also observed that, with the above selected ranges, the second electrode of the invention has similar current density than the one of WALL structure, the heat being well concentrated below the heater region. Moreover, the truncated conical shape of the heater provides a resistance gradient, in which the further from the contact, the higher in resistance. As a result, we observe much less heat loss along the heater compared to a homogenous WALL electrode.

The performances of the second electrode may be even improved by the following selected ranges.

Preferentially, the height h1 (i.e. measured along the z axis) of the hollow truncated cylinder 9 is between 30 and 150 nm.

Preferentially, the height t of the solid cylinder 8 is comprised in the range between 1 nm and 5 nm. One has further to note that the height t of the cylinder corresponds to the constant thickness of conductive material forming the second electrode 5 along the flanks of said electrode 5 as illustrated in Fig. 2 c.

Preferentially, the cumulated height e of the hollow cylinder and the solid cylinder is between 5 nm and 10 nm.

In other words, very advantageously, the second electrode may present a combination of the following ranges: the outer diameter 2.r0 of the first end 10 of the hollow truncated cone 9 is between 19 nm and 100 nm, for instance 50nm; the outer diameter 2.Rout of the second end 11 of the hollow truncated cone 9 is between 14 nm and 32 nm, for instance 14nm; the angle θ between the sides 12 of the hollow truncated cone 9 and the top surface 13 of the hollow cylinder 8 is between 75° and 87°, for instance 80°; the height h1 of the hollow truncated cylinder 9 is between 50 and 100 nm, for instance 100 nm; the height t of the solid cylinder 7 is between 1 nm and 5 nm, for instance 3 nm; the cumulated height e of the hollow cylinder 7 and the solid cylinder 8 is between 5 nm and 10 nm, for instance 10 nm.

A dielectric material 14 such as SiO₂ surrounds the external sides 15 of the hollow truncated cone; the hollow truncated cone 9 and the hollow cylinder 8 are also filled with a dielectric material 14 that may be the same as the dielectric material surrounding the external sides 15 or another dielectric material.

One has to note that, even if the invention has been especially disclosed in the case of a PCM resistive device, the resistive device of the invention may also concern other types of ReRAM (Resistive Random Access Memory) such as CBRAM or "Conductive Bridging RAM" memories, metal oxide materials (OxRAM or "Oxide Resistive RAM" memories) or ferroelectric materials (FERAM or "Ferroelectric RAM" memories). The restive device of the invention may also be used as a selector device such as FAST ("Field Assisted Superlinear Threshold"), MIEC ("Mixed-lonic-Electronic Conduction") and OTS ("Ovonic Threshold Switching") selectors.

Fig. 3 to Fig. 10 show a schematic representation of steps 100 to 107 of a manufacturing method of a resistive device according to the invention.

The first step 100 (Fig. 3) of the manufacturing method of the invention consists in providing a conductive layer 200 adapted to form the first conductive electrode (bottom electrode) of the device. This conductive layer 200 may be patterned to get the desired shape and dimension of said first electrode. As mentioned before, the first electrode 200 may be arranged on a non-represented dielectric layer or on a metal level at back end of the line (BEOL).

The second step 101 (Fig. 4) consists of successively depositing:
- a layer made of an active PCM material 201;
- a protecting layer 202;
- an etch stop layer 203;
- an insulating dielectric layer 204 made of a first dielectric material such as an oxide.

The deposition 101 can be a Physical Vapor Deposition or PVD, a Chemical Vapor Deposition or CVD, or an Atomic Layer Deposition or ALD. It is also possible to use a sputtering technique to form the active PCM layer 201.

The third step 102 (Fig. 5) consists of etching the insulating dielectric layer 204 and the etch stop layer 203 with a stop of etching on the surface of the protecting layer 202 so as to pattern a cavity 205. Said etching may be for instance carried out by Reactive Ion Etching RIE. The etch stop layer 203 is chosen to create an etch selectivity between insulating layer 204 and protective layer 202 and may be for example made of SiN.

The cavity 205 has a hollow cylinder shape 206 through the etched etch stop layer 203 and a hollow truncated cone shape 207 through the insulating layer 204, the first end of the hollow truncated cone having the same outer diameter as the outer diameter of the hollow cylinder 207 and being positioned facing the hollow cylinder 206, the second end of the hollow truncated cone 207 having an outer diameter strictly greater than the outer diameter of the first end of the hollow truncated cone 207.

The PCM active material of the active layer 201 is especially sensitive to etching chemicals and air; therefore, the protection layer 202 may be advantageously required.

The top critical dimension CD (i.e. the top diameter) of the patterned cavity represents the current lithography technology limit (current immersive lithography tools provide for instance a limit of 54 nm in CD).

The fourth step 206 (Fig. 6) consists of a conformal deposition of a conductive layer 208 on the flank and the bottom of the cavity 205 so as to form a second conductive electrode 209 comprising:
- a solid cylinder 210 contacting the first face of the protecting layer 202,
- a hollow cylinder 211 of same outer diameter as the outer diameter of the solid cylinder 210 and positioned facing the solid cylinder, and
- a hollow truncated cone 212 having a first end and a second end, the first end of the hollow truncated cone having the same outer diameter as the outer diameter of the hollow cylinder and being positioned facing the hollow cylinder, the second end of the hollow truncated cone having an outer diameter strictly greater than the outer diameter of the first end of the hollow truncated cone.

The dimensions of the patterned cavity are chosen in order to have an outer diameter of the first end of the hollow truncated cone between 14 nm and 32 nm and an angle between the sides of the hollow truncated cone and the top surface of the hollow cylinder being between 75° and 87°. Said angle is limited by etching development.

It is meant by "conformal deposition" a material deposition process that uniformly covers the surface on which it is deposited, including the sidewalls and bottom of raised or recessed structures. The main characteristic of a conformal deposition is its uniform thickness (i.e. The deposited material maintains a consistent thickness across all surfaces, regardless of topography).

Step 206 of conformal deposition is for instance carried out by an ALD deposition.

Fig. 7 illustrates the fifth step 104 of the method of the invention consisting in filling the previously etched cavity 205 wherein the second conductive electrode 209 has been formed and in covering the parts of the conductive material layer 208 filed on the part that has not been etched in the previous etching step, with a dielectric material layer 213.

Said dielectric material 213 may be the same as the material of the insulating layer 204 or another dielectric material.

Filling and deposition step 104 may be, for example, performed by plasma enhanced chemical vapor deposition or PECVD.

Fig. 8 illustrates the sixth step 105 of the method of the invention consisting in performing a planarization, for instance a Chemical Mechanical Planarization (CMP) in order to remove part of the dielectric material and the conductive material so that the desired height of the second electrode 209 is obtained. This sixth step 105 may be very interesting because it allows starting from an initial height of the cone that is relatively high and, thanks to the CMP, having a height gain of between 30 and 50% on z-axis compared to the know Wall-type electrode, while keeping the desired resistance and respecting the lithography limit.

Fig. 9 shows an illustration of the seventh step of the method according to the invention comprising a step 106 of deposition of a conductive layer 214 in order to form the top electrode contact 214 of the resistive device. The deposition step 106 can be for instance a PVD, a CVD, or an ALD.

Fig. 10 illustrates the eighth step 107 of the method of the invention consisting in performing an etching of the stack of layers to form the memory cell.

## Claims

1. A resistive device comprising:
- a first conductive electrode,
- a second conductive electrode; and
- a layer made of an active material, called active layer, said active layer being between the first electrode and the second electrode, a first face of the active layer being electrically connected to the second electrode and a second face of the active layer being electrically connected to the first electrode;
wherein the second electrode comprises:
- a solid cylinder contacting the first face of the active layer either directly or through a protecting layer,
• a hollow cylinder of same outer diameter as the outer diameter of the solid cylinder and positioned facing the solid cylinder, and
• a hollow truncated cone having a first end and a second end, the first end of the hollow truncated cone having the same outer diameter as the outer diameter of the hollow cylinder and being positioned facing the hollow cylinder, the second end of the hollow truncated cone having an outer diameter strictly greater than the outer diameter of the first end of the hollow truncated cone,
the outer diameter of the first end of the hollow truncated cone being between 14 nm and 32 nm, the outer diameter of the second end of the hollow truncated cone being between 19 nm and 100 nm and the angle between the sides of the hollow truncated cone and the top surface of the hollow cylinder being between 75° and 87°.

2. The device according to the previous claim wherein the outer diameter of the second end of the hollow truncated cone is between 30 nm and 100 nm.

3. The device according to anyone of the previous claims wherein the height of the hollow truncated cylinder is between 30 and 150 nm

4. The device according to anyone of the previous claims wherein the height of the solid cylinder is between 1 nm and 5 nm.

5. The device according to anyone of the previous claims wherein the cumulated height of the hollow cylinder and the solid cylinder is between 5 nm and 10 nm.

6. The device according to anyone of the previous claims wherein said device is a phase change memory, said active layer being made of a phase change material and said second electrode being the heater of said phase change memory.

7. The device according to the previous claim wherein said phase change material is a chalcogenide material.

8. The device according to anyone of the previous claims wherein a dielectric material surrounds the external sides of the hollow truncated cone, said hollow truncated cone and said hollow cylinder being also filled with a dielectric material.

9. The device according to anyone of the previous claims comprising a protection layer located between said active layer and said second electrode.

10. The device according to anyone of the previous claims wherein said second electrode is at least part of the top electrode of the device and said first electrode is the bottom electrode of the device.

11. A method for manufacturing a resistive device comprising the steps of:
- Providing a conductive layer adapted to form a first conductive electrode;
- Depositing a layer made of an active material;
- Depositing a protecting layer;
- Depositing an etch stop layer;
- Depositing an insulating layer;
- Etching the insulating layer and the etch stop layer with stopping on the surface of the protecting layer, so as to pattern a cavity having a hollow cylinder shape through the etch stop layer and a hollow truncated cone shape having a first end and a second end, the first end of the hollow truncated cone having the same outer diameter as the outer diameter of the hollow cylinder and being positioned facing the hollow cylinder, the second end of the hollow truncated cone having an outer diameter strictly greater than the outer diameter of the first end of the hollow truncated cone;
- Conformally depositing a conductive layer on the flank and the bottom of the cavity so as to form a second conductive electrode comprising:
- a solid cylinder contacting the first face of the protecting layer,
- a hollow cylinder of same outer diameter as the outer diameter of the solid cylinder and positioned facing the solid cylinder, and
- a hollow truncated cone having a first end and a second end, the first end of the hollow truncated cone having the same outer diameter as the outer diameter of the hollow cylinder and being positioned facing the hollow cylinder, the second end of the hollow truncated cone having an outer diameter strictly greater than the outer diameter of the first end of the hollow truncated cone;
the outer diameter of the first end of the hollow truncated cone being between 14 nm and 32 nm, the outer diameter of the second end of the hollow truncated cone being between 19 nm and 100 nm and the angle between the sides of the hollow truncated cone and the top surface of the hollow cylinder being between 75° and 87°.

12. The manufacturing method according to claim 11, comprising a step of depositing an insulation layer so as to fill said hollow truncated cone and said hollow cylinder.

13. The manufacturing according to claim 12, comprising a step of polishing so as to obtain a desired height of the second conductive electrode and the desired outer diameter of the second end of the hollow truncated cone.

14. The manufacturing method according to anyone of claims 11 to 13, wherein the height of the hollow truncated cylinder is between 50 and 100 nm and the height of the solid cylinder is between 1 nm and 5 nm.

15. The manufacturing method of anyone of claims 12 to 14, comprising a step of depositing a conductive layer contacting the top part of the second electrode so as to form a top electrode contact.
